# EUROPEAN PATENT APPLICATION

(11) **EP 4 442 868 A1**
(43) Date of publication of application: **09.10.2024**
(21) Application number: 22900973.3
(22) Date of filing: 25.10.2022
(51) Int. Cl.: C30B 29/38, C23C 16/34, C30B 25/18, C30B 29/06, H01L 21/20, H01L 21/205

(54) **NITRIDE SEMICONDUCTOR SUBSTRATE AND METHOD FOR PRODUCING SAME**

(30) Priority: 30.11.2021 JP 2021193940
(71) Applicant: Shin-Etsu Handotai Co., Ltd., Tokyo 100-0004 (JP)
(72) Inventor: KUBONO, Ippei, Annaka-shi, Gunma 379-0196 (JP); TSUCHIYA, Keitaro, Annaka-shi, Gunma 379-0196 (JP); HAGIMOTO, Kazunori, Annaka-shi, Gunma 379-0196 (JP); MIHARA, Keisuke, Nishishirakawa-gun, Fukushima 961-8061 (JP); SUGAWARA, Kosei, Nishishirakawa-gun, Fukushima 961-8061 (JP)
(74) Representative: Mooser, Sebastian Thomas
(86) International application number: PCT/JP2022/039792
(87) International publication number: WO 2023/100540

(57) **Abstract**

The present invention is a nitride semiconductor substrate including: a silicon single-crystal substrate; and a nitride semiconductor thin film formed on the silicon single-crystal substrate, wherein the silicon single-crystal substrate has a carbon concentration of 5E16 atoms/cm³ or more and 2E17 atoms/cm³ or less. This provides a nitride semiconductor substrate resistant against plastic deformation and a manufacturing method therefor.

## Description

### TECHNICAL FIELD

The present invention relates to a nitride semiconductor substrate with a metal organic chemical vapor deposition (MOCVD) method, and a manufacturing method therefor.

### BACKGROUND ART

An MOCVD method, which is one of methods for manufacturing a semiconductor thin film, is widely used because of excellence in increasing a diameter and mass productivity, and ability to form a uniform thin-film crystal. A nitride semiconductor represented by GaN has been promising as a next-generation semiconductor material to exceed a limit as a Si material. GaN can be used for producing a device operable at high frequency due to its characteristics of a large saturation electron speed, and can operate at high output because of a large dielectric breakdown field. Reduction in weight, size, and power consumption are also expected. With a demand for increasing a communication speed represented by 5G etc. and increasing output with the increase in the communication speed, GaN HEMT that can operate at high frequency and high output has attracted attention in recent years.

As a substrate used for a GaN epitaxial wafer for producing the GaN device, a silicon single-crystal substrate is most inexpensive and advantageous for increasing a diameter. In forming a GaN film on the silicon single-crystal substrate by the MOCVD method, a stress is applied during film formation and cooling due to a difference in thermal expansion coefficient between GaN and Si. To prevent plastic deformation due to this stress, a silicon single-crystal substrate having a thickness (for example, 1 mm, 1.15 mm, etc.) larger than the thickness of SEMI spec is often used. However, an apparatus in a device process may be constituted in accordance with the SEMI standard, and in this case, the thick substrate cannot be placed in the device process. Thus, a silicon single-crystal substrate having the thickness of the SEMI standard is preferably used as much as possible.

However, the silicon single-crystal substrate having the thickness of the SEMI standard is as thin as 675 um for a wafer with 150 mm in diameter or as 725 um for a wafer with 200 mm in diameter. There is a problem that such a substrate cannot be durable against the stress in GaN film formation to cause plastic deformation under some growth conditions such as film formation of thick GaN. Particularly, a silicon single-crystal substrate for a high-frequency device is required to be a high-resistant substrate with 1000 Ω·cm or more, but a wafer with a low dopant concentration and a high resistivity easily causes the plastic deformation.

Patent Document 1 describes a silicon single-crystal substrate having resistance against plastic deformation due to stress in GaN film formation by doping the silicon single-crystal substrate with oxygen and nitrogen. The silicon single-crystal substrate doped with oxygen and nitrogen described in Patent Document 1 has resistance against the plastic deformation compared with the non-doped silicon single-crystal substrate, but the resistance may be insufficient depending on the film thickness of GaN to be formed.

### CITATION LIST

### PATENT LITERATURE

Patent Document 1: JP 6866952 B

### SUMMARY OF INVENTION

### TECHNICAL PROBLEM

The present invention has been made to solve the above problem. An object of the present invention is to provide a nitride semiconductor substrate having resistance against the plastic deformation, and a manufacturing method therefor.

### SOLUTION TO PROBLEM

To solve the above problem, the present invention provides a nitride semiconductor substrate comprising:
a silicon single-crystal substrate; and
a nitride semiconductor thin film formed on the silicon single-crystal substrate,
wherein the silicon single-crystal substrate has a carbon concentration of 5E16 atoms/cm³ or more and 2E17 atoms/cm³ or less.

The silicon single-crystal substrate doped with carbon within such a concentration range yields the resistance against the plastic deformation to yield the nitride semiconductor substrate with reduced warp.

The silicon single-crystal substrate preferably has an oxygen concentration of 5E17 atoms/cm³ or more and 5E18 atoms/cm³ or less, and a nitrogen concentration of 1E14 atoms/cm³ or more and 5E16 atoms/cm³ or less.

Such a nitride semiconductor substrate can further inhibit the plastic deformation.

The silicon single-crystal substrate is preferably produced by a CZ method.

With the CZ method, the wafer with a large diameter doped with predetermined concentrations of oxygen, nitrogen, and carbon can be relatively easily produced.

The silicon single-crystal substrate preferably has a crystal surface orientation of (111) and a resistivity of 1000 Ω·cm or more.

The crystal surface orientation of (111) facilitates epitaxial growth of the nitride semiconductor thin film, and the resistivity of 1000 Ω·cm or more can yield the substrate for an electronic device having excellent high-voltage resistance and high-frequency characteristics.

The nitride semiconductor thin film preferably contains gallium nitride.

In the present invention, the nitride semiconductor thin film can have such a configuration.

In addition, the present invention also provides a method for manufacturing a nitride semiconductor substrate comprising a silicon single-crystal substrate and a nitride semiconductor thin film formed on the silicon single-crystal substrate, the method comprising steps of:
(1) preparing a silicon single-crystal substrate having a carbon concentration of 5E16 atoms/cm³ or more and 2E17 atoms/cm³ or less; and
(2) forming a nitride semiconductor thin film on the silicon single-crystal substrate.

By such a manufacturing method, the plastic deformation during growth of the nitride semiconductor thin film can be inhibited to manufacture the nitride semiconductor substrate with reduced warp.

The silicon single-crystal substrate prepared in the step (1) preferably has an oxygen concentration of 5E17 atoms/cm³ or more and 5E18 atoms/cm³ or less, and a nitrogen concentration of 1E14 atoms/cm³ or more and 5E16 atoms/cm³ or less.

Such a configuration can further inhibit the plastic deformation.

The silicon single-crystal substrate prepared in the step (1) is preferably produced by a CZ method.

With the CZ method, the wafer with a large diameter doped with predetermined concentrations of oxygen, nitrogen, and carbon can be relatively easily produced.

The silicon single-crystal substrate prepared in the step (1) preferably has a crystal surface orientation of (111) and a resistivity of 1000 Ω·cm or more.

The crystal surface orientation of (111) facilitates epitaxial growth of the nitride semiconductor thin film, and the resistivity of 1000 Ω·cm or more can yield the substrate for an electronic device having excellent high-voltage resistance and high-frequency characteristics.

The nitride semiconductor thin film formed in the step (2) preferably contains gallium nitride.

In the present invention, the nitride semiconductor thin film can have such a configuration.

### ADVANTAGEOUS EFFECTS OF INVENTION

As above, the present invention can provide the nitride semiconductor substrate having resistance against the plastic deformation and a manufacturing method therefor.

### BRIEF DESCRIPTION OF DRAWINGS

FIG. 1 is a schematic view illustrating an example of a nitride semiconductor substrate of the present invention.
FIG. 2 is a schematic view illustrating an example of an MOCVD apparatus usable for a method for manufacturing a nitride semiconductor substrate of the present invention.
FIG. 3 is a graph indicating comparison of curvature at which a plastic deformation is observed in epitaxial growth in Example 1, Example 2, Comparative Example 1, and Comparative Example 2.
FIG. 4 is a graph indicating a relationship between a carbon concentration in a silicon single-crystal substrate and a curvature at which a plastic deformation is observed in GaN film formation in Examples 3 and 4 and Comparative Examples 3 to 6.

### DESCRIPTION OF EMBODIMENTS

As noted above, in forming a GaN-containing nitride semiconductor thin film on the silicon single-crystal substrate by the MOCVD method, a stress is applied during film formation and cooling due to a difference in thermal expansion coefficient between GaN and Si. Accordingly, there is a problem that the substrate cannot be durable against this stress to cause plastic deformation.

The present inventors have made earnest study to solve the above problem, and consequently found that the plastic deformation can be inhibited by setting the carbon concentration in the silicon single-crystal substrate to 5E16 atoms/cm³ or more and 2E17 atoms/cm³ or less. This finding has led to completion of the present invention.

Specifically, the present invention is a nitride semiconductor substrate comprising: a silicon single-crystal substrate; and a nitride semiconductor thin film formed on the silicon single-crystal substrate, wherein the silicon single-crystal substrate has a carbon concentration of 5E16 atoms/cm³ or more and 2E17 atoms/cm³ or less.

In addition, the present invention is a method for manufacturing a nitride semiconductor substrate comprising a silicon single-crystal substrate and a nitride semiconductor thin film formed on the silicon single-crystal substrate, the method comprising steps of: (1) preparing a silicon single-crystal substrate having a carbon concentration of 5E16 atoms/cm³ or more and 2E17 atoms/cm³ or less; and (2) forming a nitride semiconductor thin film on the silicon single-crystal substrate.

Hereinafter, the present invention will be described in detail, but the present invention is not limited thereto.

### Nitride Semiconductor Substrate

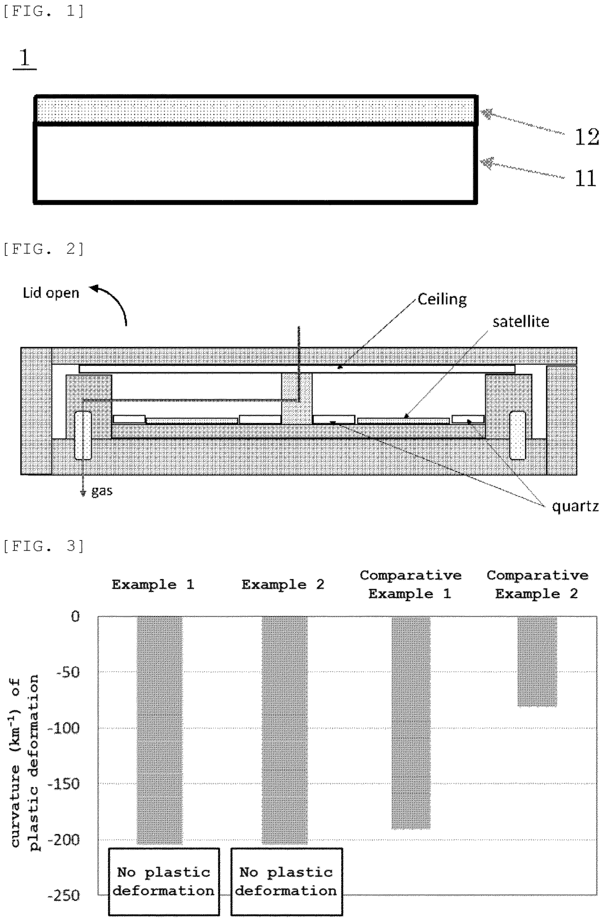

FIG. 1 illustrates an example of the nitride semiconductor substrate of the present invention. A nitride semiconductor substrate 1 of the present invention has a silicon single-crystal substrate 11 and a nitride semiconductor thin film 12 formed thereon, and the silicon single-crystal substrate 11 has a carbon concentration of 5E16 atoms/cm³ or more and 2E17 atoms/cm³ or less.

The above nitride semiconductor substrate in which the nitride semiconductor thin film is formed on the silicon single-crystal substrate having a carbon concentration of 5E16 atoms/cm³ or more can inhibit the plastic deformation to reduce warp. In producing the silicon single crystal by the CZ method, it is difficult to perform doping at a carbon concentration of higher than 2E17 atoms/cm³ from the viewpoints of a solid solution degree of the carbon concentration in Si and the manufacturing apparatus.

The carbon concentration in the silicon single-crystal substrate is preferably 5E16 atoms/cm³ or more and 1.5E17 atoms/cm³ or less, and more preferably 5E16 atoms/cm³ or more and 1E17 atoms/cm³ or less.

Doping concentrations of other elements in the silicon single-crystal substrate are not particularly limited. In addition to the carbon concentration within the above range, the oxygen concentration is preferably 5E17 atoms/cm³ or more and 5E18 atoms/cm³ or less, and the nitrogen concentration is preferably 1E14 atoms/cm³ or more and 5E16 atoms/cm³ or less. With such a nitride semiconductor substrate, the plastic deformation can be further inhibited.

The silicon single-crystal substrate is not particularly limited as long as the carbon concentration is within the above range, but the substrate is preferably produced by the CZ method. With the CZ method, the wafer with a large diameter doped with predetermined concentrations of oxygen, nitrogen, and carbon can be relatively easily manufactured.

The surface orientation of the main surface of the silicon single-crystal substrate is not particularly limited and may be (100), (110), (111), etc., and preferably (111). The crystal surface orientation of (111) facilitates epitaxial growth of the nitride semiconductor thin film.

The resistivity of the silicon single-crystal substrate is not particularly limited, and preferably 1000 Ω·cm or more, for example. The upper limit of the resistivity is also not limited, and may be 100000 Ω·cm or less, for example. The resistivity of 1000 Ω·cm or more can yield the substrate for an electronic device having excellent high-voltage resistance and high-frequency characteristics.

The nitride semiconductor thin film is not particularly limited, and may be an epitaxial layer as follows, for example. The nitride semiconductor thin film preferably contains gallium nitride.

### Method for Manufacturing Nitride Semiconductor Substrate

The nitride semiconductor substrate of the present invention can be manufactured by a method for manufacturing a nitride semiconductor substrate of the present invention as follows.

### <Step (1) Step of Preparing Silicon Single-Crystal Substrate>

The step (1) is a step of preparing a silicon single-crystal substrate having a carbon concentration of 5E16 atoms/cm³ or more and 2E17 atoms/cm³ or less. The step (1) can be performed as follows, for example.

A silicon ingot with an axial orientation of <111> is produced by the CZ method. In this time, a carbon source material (for example, carbon powder etc.) is doped to the raw material so that the grown crystal has a carbon concentration of 5E16 atoms/cm³ or more and 2E17 atoms/cm³ or less, thereby a single crystal is grown. The silicon single-crystal substrate having such a carbon concentration can inhibit plastic deformation during the epitaxial growth, thereby the warp of the nitride semiconductor substrate is reduced after cooling.

In this time, the manufacturing conditions are preferably set so that the oxygen concentration is 5E17 atoms/cm³ or more and 5E18 atoms/cm³ or less, and the raw material is preferably doped with nitrogen so that the nitrogen concentration is 1E14 atoms/cm³ or more and 5E16 atoms/cm³ or less. The material containing the predetermined amounts of oxygen and nitrogen as above can further inhibit the plastic deformation.

Then, the produced silicon ingot is sliced to form a wafer, and the silicon single-crystal substrate having a carbon concentration of 5E16 atoms/cm³ or more and 2E17 atoms/cm³ or less is prepared.

### <Step (2) Step of Epitaxially Growing Nitride Semiconductor Thin Film>

The step (2) is a step of forming the nitride semiconductor thin film on the silicon single-crystal substrate. The step (2) can be performed as follows, for example.

In the MOCVD reaction furnace as illustrated in FIG. 2, the group III nitride semiconductor thin film such as AlN, AlGaN, and GaN is epitaxially grown on the silicon single-crystal substrate. The structure of the epitaxial layer is not limited thereto, and sometimes an AlGaN film is not formed, or an AlN film may be further formed after forming the AlGaN film. In addition, a plurality of AlGaN layers with changed Al compositions may be formed. The film thickness is changed depending on use, and thus not particularly limited.

A device layer may be provided on the surface layer side of the epitaxial layer. The device layer may have a structure in which provided are a layer with high crystallinity to generate a two-dimensional electron gas (channel layer), a layer to generate a two-dimensional electron gas (barrier layer), and a cap layer on the outermost layer. As the barrier layer, AlGaN having an Al composition of approximately 20% may be used, and InGaN etc. may also be used for example, and not limited thereto. The cap layer may be, for example, a GaN layer and a SiN layer, and the cap layer is also not limited thereto. The thickness of these device layers and the Al composition of the barrier layer are changed depending on the device design.

In the epitaxial growth, TMAl may be used as an Al source, TMGa may be used as a Ga source, and NH₃ may be used as a N source. The carrier gas may be N₂ and H₂, or either of them, and the process temperature may be approximately 900 to 1300°C.

In the epitaxial growth, a stress is applied to the silicon single-crystal substrate due to a difference in thermal expansion coefficient between GaN and Si. However, in the present invention, the silicon single-crystal substrate having a carbon concentration within the above range can prevent the plastic deformation due to this stress. Therefore, the nitride semiconductor thin film can be thickly grown to improve a degree of freedom of the device design.

### EXAMPLE

Hereinafter, the present invention will be specifically described by using Examples and Comparative Examples, but the present invention is not limited thereto.

### (Example 1)

A silicon single crystal with 150 mm in diameter and an axial orientation of <111> was grown by a CZ method. In this time, manufacturing conditions were regulated so that the carbon concentration was 8.6E16 atoms/cm³ and the oxygen concentration was 5.6E17 atoms/cm³. A cylinder-shaped silicon ingot was produced, and processed into a polished wafer with 675 um in thickness to prepare a silicon single-crystal substrate.

This silicon single-crystal substrate was placed in the MOCVD reaction furnace as illustrated in FIG. 2, and a group III nitride semiconductor thin film such as AlN, AlGaN, and GaN was epitaxially grown on the silicon single-crystal substrate. The silicon single-crystal substrate was placed on a wafer pocket called "satellite". In the epitaxial growth, TMAl was used as an Al source, TMGa was used as a Ga source, and NH₃ was used as a N source. As a carrier gas, both of N₂ and H₂ were used. The process temperature was approximately 900 to 1300°C. The silicon single-crystal substrate was placed on the satellite, and in the epitaxial growth, an AlN film and an AlGaN film were formed in this order from the substrate side toward the growth side as epitaxial layers, and then GaN was epitaxially grown.

A device layer was provided on the surface layer side of the epitaxial layer. Formed as the device layer were 400 nm of a layer with high crystallinity to generate a two-dimensional electron gas (channel layer), and 20 nm of a barrier layer to generate a two-dimensional electron gas and composed of AlGaN with an Al composition of 20%. The structure had a cap layer composed of 3 nm GaN provided on the outermost layer. The total film thickness of the epitaxially grown nitride semiconductor thin film was 6.5 µm.

Warp of the substrate during the epitaxial growth was measured in real time to record a point of plastic deformation due to a stress (the curvature of the substrate at which a plastic deformation is observed). FIG. 3 shows the results. Warp of the nitride semiconductor substrate after the film formation was measured. Table 1 shows the results.

### (Example 2)

A silicon ingot having an oxygen concentration of 1.6E18 atoms/cm³, a nitrogen concentration of 2.0E14 atoms/cm³, and a carbon concentration of 8.6E16 atoms/cm³ was produced, processed into the same shape as in Example 1, and then a nitride semiconductor thin film was epitaxially grown under the same conditions as in Example 1. The measurement was also performed in the same manner as in Example 1, and comparison was performed. FIG. 3 and Table 1 show the result.

### (Comparative Example 1)

A silicon ingot having an oxygen concentration of 1.6E18 atoms/cm³, a nitrogen concentration of 2.0E14 atoms/cm³, and no-doped carbon was produced, processed into the same shape as in Example 1, and then a nitride semiconductor thin film was epitaxially grown under the same conditions as in Example 1. The measurement was also performed in the same manner as in Example 1, and comparison was performed. FIG. 3 and Table 1 show the result.

### (Comparative Example 2)

A silicon ingot having an oxygen concentration of 5E17 atoms/cm³ and no-doped carbon was produced, processed into the same shape as in Example 1, and then a nitride semiconductor thin film was epitaxially grown under the same conditions as in Example 1. The measurement was also performed in the same manner as in Example 1, and comparison was performed. FIG. 3 and Table 1 show the result.

**[Table 1]**

| | Warp (µm) after GaN film formation |
|---|---|
| Example 1 | 22.3 |
| Example 2 | 8.5 |
| Comparative Example 1 | 173 |
| Comparative Example 2 | 1076.75 |

As shown in FIG. 3, in Examples 1 and 2 being the present invention, the silicon single-crystal substrate was doped with the predetermined amount of carbon and therefore plastic deformation did not occur during the epitaxial growth. Meanwhile, in Comparative Examples 1 and 2 in which the silicon single-crystal substrate was not doped with carbon, plastic deformation occurred during the epitaxial growth. Therefore, as shown in Table 1, Examples 1 and 2 yielded the nitride semiconductor substrate with reduced warp compared with Comparative Examples 1 and 2. Particularly, it was found that Example 2 in which the silicon single-crystal substrate was doped with the predetermined amounts of carbon, oxygen, and nitrogen furthermore inhibited the warp.

In FIG. 3, a larger curvature at which a plastic deformation is observed means higher resistance against the plastic deformation (higher strength). A negative curvature means upward protrusion, and a positive curvature means downward protrusion.

### (Examples 3 and 4, and Comparative Examples 3 to 6)

Silicon single crystals having a diameter of 150 mm and an axial orientation of <111> were grown by the CZ method by changing the manufacturing conditions such that the carbon concentration was the following value. The oxygen concentration was almost constant at approximately 6E17 atoms/cm³. Each of the ingots was processed into a cylindrical shape and processed into a polished wafer with 675 um in thickness to prepare a silicon single-crystal substrate.
(Comparative Example 3) Carbon concentration 1.77E15 atoms/cm³
(Comparative Example 4) Carbon concentration 5.1E15 atoms/cm³
(Comparative Example 5) Carbon concentration 9.1E15 atoms/cm³
(Comparative Example 6) Carbon concentration 2.21E16 atoms/cm³
(Example 3) Carbon concentration 5.2E16 atoms/cm³
(Example 4) Carbon concentration 7.9E16 atoms/cm³

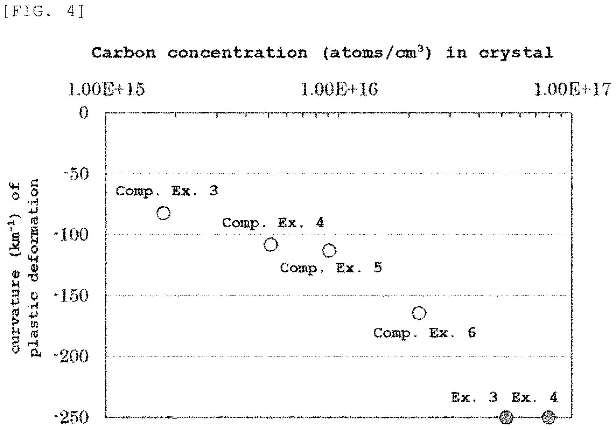

A nitride semiconductor thin film was epitaxially grown on these silicon single-crystal substrates under the same conditions as in Example 1. Warp of the substrate during the epitaxial growth was measured in real time to record a point of plastic deformation due to a stress (the curvature of the substrate at which a plastic deformation is observed). FIG. 4 shows the results.

As shown in FIG. 4, in Examples 3 and 4 being the present invention, the silicon single-crystal substrate was doped with the predetermined amount of carbon and therefore plastic deformation was not observed during the epitaxial growth. (Although Examples 3 and 4 completed the GaN film formation without plastic deformation, plotting was performed for convenience.) Meanwhile, Comparative Examples 3 to 6 in which the doping amount of carbon was small were found to fail to inhibit the plastic deformation during the epitaxial growth. Particularly, as obvious from Example 3 and Comparative Example 6, it has been found that a carbon concentration of 5E16 atoms/cm³ or more prevents the plastic deformation.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A nitride semiconductor substrate, comprising:
a silicon single-crystal substrate; and
a nitride semiconductor thin film formed on the silicon single-crystal substrate,
wherein the silicon single-crystal substrate has a carbon concentration of 5E16 atoms/cm³ or more and 2E17 atoms/cm³ or less.

2. The nitride semiconductor substrate according to claim 1, wherein the silicon single-crystal substrate has an oxygen concentration of 5E17 atoms/cm³ or more and 5E18 atoms/cm³ or less, and a nitrogen concentration of 1E14 atoms/cm³ or more and 5E16 atoms/cm³ or less.

3. The nitride semiconductor substrate according to claim 1 or 2, wherein the silicon single-crystal substrate is produced by a CZ method.

4. The nitride semiconductor substrate according to any one of claims 1 to 3, wherein the silicon single-crystal substrate has a crystal surface orientation of (111) and a resistivity of 1000 Ω·cm or more.

5. The nitride semiconductor substrate according to any one of claims 1 to 4, wherein the nitride semiconductor thin film contains gallium nitride.

6. A method for manufacturing a nitride semiconductor substrate comprising a silicon single-crystal substrate and a nitride semiconductor thin film formed on the silicon single-crystal substrate, the method comprising steps of:
(1) preparing a silicon single-crystal substrate having a carbon concentration of 5E16 atoms/cm³ or more and 2E17 atoms/cm³ or less; and
(2) forming a nitride semiconductor thin film on the silicon single-crystal substrate.

7. The method for manufacturing a nitride semiconductor substrate according to claim 6, wherein the silicon single-crystal substrate prepared in the step (1) has an oxygen concentration of 5E17 atoms/cm³ or more and 5E18 atoms/cm³ or less, and a nitrogen concentration of 1E14 atoms/cm³ or more and 5E16 atoms/cm³ or less.

8. The method for manufacturing a nitride semiconductor substrate according to claim 6 or 7, wherein the silicon single-crystal substrate prepared in the step (1) is produced by a CZ method.

9. The method for manufacturing a nitride semiconductor substrate according to any one of claims 6 to 8, wherein the silicon single-crystal substrate prepared in the step (1) has a crystal surface orientation of (111) and a resistivity of 1000 Ω·cm or more.

10. The method for manufacturing a nitride semiconductor substrate according to any one of claims 6 to 9, wherein the nitride semiconductor thin film formed in the step (2) contains gallium nitride.
